# EUROPEAN PATENT APPLICATION

(11) **EP 3 001 432 A1**
(43) Date of publication of application: **30.03.2016**
(21) Application number: 14801677.7
(22) Date of filing: 20.05.2014
(51) Int. Cl.: H01F 6/00, H01F 6/06

(54) **OXIDE SUPERCONDUCTING BULK MAGNET**

(30) Priority: 22.05.2013 JP 2013108242; 04.02.2014 JP 2014019655
(71) Applicant: Nippon Steel & Sumitomo Metal Corporation, Tokyo 100-8071 (JP)
(72) Inventor: MORITA, Mitsuru, Tokyo 100-8071 (JP); TESHIMA, Hidekazu, Tokyo 100-8071 (JP)
(74) Representative: Vossius & Partner Patentanwälte Rechtsanwälte mbB
(86) International application number: PCT/JP2014/063333
(87) International publication number: WO 2014/189043

(57) **Abstract**

The present invention provides an oxide superconducting bulk magnet which enables a superconducting bulk member to be made larger without fracture when making it generate a high magnetic field and an oxide superconducting bulk magnet including the same. A ring-shaped oxide superconducting bulk magnet comprised of a superconducting phase in which a nonsuperconducting phase is finely dispersed is reinforced at its outer circumference part and inner circumference part by ring-shaped reinforcing materials. Furthermore, at its inside, a ring-shaped oxide superconducting bulk magnet which is reinforced at its outer circumference part by a reinforcing material is combined in a nested manner to form an integral oxide superconducting bulk magnet, whereby it is possible to form a higher magnetic field while making fractures harder.

## Description

### Technical Field

The present invention relates to an oxide superconducting bulk magnet

### Background Art

An oxide superconducting material comprised of an REBa₂Cu₃O₇₋ₓ ("RE" indicates a rare earth element or a combination of the same) phase in which an RE₂BaCuO₅ phase is dispersed has a high critical current density (J_{c}). For this reason, cooling in a magnetic field or pulse magnetization enables excitation whereby use becomes possible in an oxide superconducting bulk state. For example, PLT 1 discloses a superconducting magnetic field generating apparatus which enables such an oxide superconducting material (oxide superconducting bulk magnet) to be used in a superconducting motor etc.

NPLT 1 discloses that a diameter 36 mm columnar-shaped Sm-based superconducting bulk magnet which was magnetized by cooling in a magnetic field can form a maximum 1.5T or so magnetic field. NPLT 2 discloses using a Y-based superconducting bulk material and comparing relatively pulse magnetization and magnetization by cooling in a magnetic field. NPLT 3 discloses that it is possible to use a diameter approximately 60 mm superconducting bulk material in superconducting magnets and form an approximately 4.5T magnetic field at 40K. In this way, regarding the pulse magnetization of an RE (rare earth element)-based superconducting bulk material, in PLT 1, pulse magnetization accompanied with a leap in magnetic flux is disclosed. Further, NPLT 2, NPLT 3, etc. disclose magnetization methods including cooling methods.

Recently, PLT 4 discloses a superconducting bulk magnet which gives a high trapped magnetic field from a low magnetic field to a high magnetic field obtained by arranging a columnar-shaped bulk superconductor (RE^{I}Ba₂Cu₃O₇₋ₓ) which has a high J_{c} characteristic in a high magnetic field at the inside of a ring-shaped bulk superconductor (RE^{II}Ba₂Cu₃O₇₋ₓ) which has a high critical current density (J_{c}) characteristic in a low magnetic field. Note that, this superconducting bulk magnet is magnetized in a stationary magnetic field.

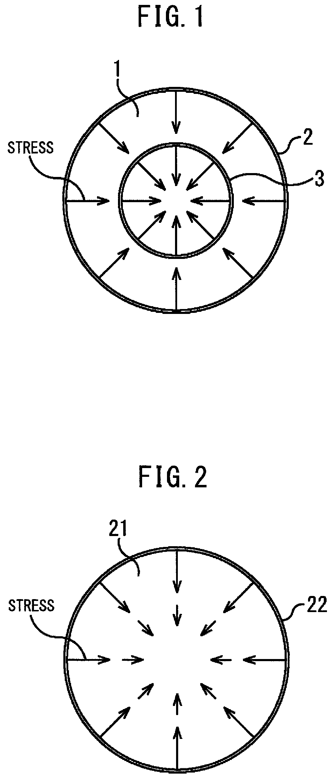

PLT 5 discloses a superconducting bulk magnet which gives a large trapped magnetic field from a low magnetic field to a high magnetic field by arranging two types or three types of RE (rare earth element)-based superconducting bulk magnets which differ in composition (that is, differ in superconducting characteristics). (See PLT 5, FIG. 1, FIG. 5, and FIG. 8.) Specifically, two types (or three types) of superconducting bulk magnets differing in critical current density characteristic are used, a magnet which has a large critical current density in a low magnetic field is arranged at the circumferential part, and a magnet having a high current density in a high magnetic field is arranged at the center part where the magnetic field strength becomes higher. Due to this, it becomes possible to form an overall strong magnetic field. As magnetization methods, the stationary magnetic field magnetization method and pulse magnetization method are described.

The oxide superconducting material which is described in PLT 6 is comprised of a plurality of hollow oxide superconducting bulk magnets so as to save on materials and lighten the weight. For the magnetization of the superconducting bulk magnets, the method of immersing the magnets in liquid nitrogen to render them a superconducting state and applying a magnetic field from the outside to trap the magnetic flux in the superconductors to obtain permanent magnets, that is, the stationary magnetic field magnetization method, is described. PLT 7 discloses elimination of the drop in characteristics due to the heat generated at the time of pulse magnetization by providing flow paths for coolant between superconductors and improving the trapped magnetic flux characteristic at the time of pulse magnetization. PLT 8 discloses arranging a ring-shaped superconducting bulk magnet in a nested manner so as to control the current paths at the time of pulse magnetization and enable uniform magnetization close to a concentric circular form. PLT 9 discloses, for similar objects to PLT 8, stacking multilayer ring-shaped superconducting bulk sheets having joints at one or more locations to restrict the current paths and using pulse magnetization to obtain a uniform trapped magnetic field distribution.

As explained above, in an RE-based (RE-Ba-Cu-O-based) oxide superconducting bulk magnet, the magnetic field strength is being improved by the configuration or method of magnetization of the oxide superconducting bulk magnet and the prevention of fracture due to the hoop force due to reinforcement by a ring at the outer circumference.

### Citations List

### Patent Literature

PLT 1: Japanese Patent Publication No. 6-20837A
PLT 2: Japanese Patent Publication No. 6-168823A
PLT 3: Japanese Patent Publication No. 10-12429A
PLT 4: Japanese Patent Publication No. 2001-358007A
PLT 5: Japanese Patent Publication No. 9-255333A
PLT 6: Japanese Patent Publication No. 7-211538A
PLT 7: Japanese Patent Publication No. 2006-319000A
PLT 8: Japanese Patent Publication No. 2011-142303A
PLT 9: Japanese Patent Publication No. 2011-199298A
PLT 10: Japanese Patent Publication No. 11-284238A
PLT 11: Japanese Patent Publication No. 11-335120A
PLT 12: Japanese Patent Publication No. 2000-178025A
PLT 13: Japanese Patent Publication No. 2001-10879A
PLT 14: Japanese Patent Publication No. 7-182934A

### Non-Patent Literature

NPLT: 1: Ikuta et al.; Journal of the Magnetics Society of Japan, Vol. 23, No. 4-1,(1999) p. 885
NPLT 2: Y. Itoh et al., Jpn J. Appl. Phys., Vol. 34, 5574 (1995)
NPLT 3: Morita et al.; Journal of the Magnetics Society of Japan, Vol. 19, No. 3. (1995), p. 744
NPLT 4: Nariki et al.; Cryogenics, Vol. 40, No. 7, 2005
NPLT 5: Teshima et al.: Cryogenics, Vol. 46, No. 3, 2011
NPLT 6: H. Ikuta et al., Advances in Superconductivity, XII p. 658
NPLT 7: T. Yamada; Physica, C392-396 (2003) 623-627

### Summary of Invention

### Technical Problem

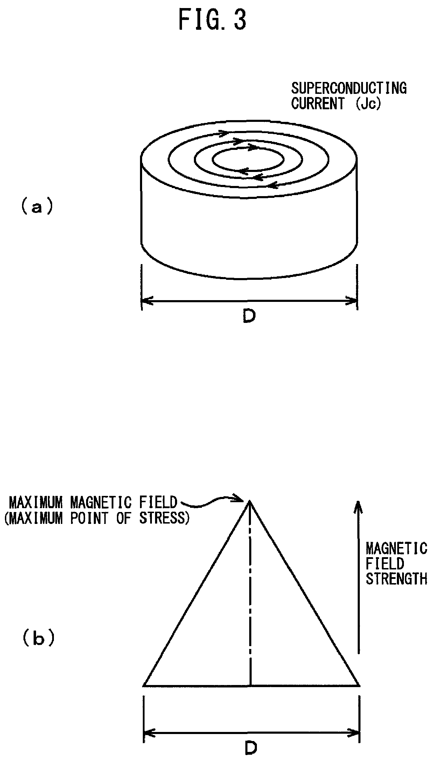

An oxide superconducting bulk magnet which is comprised of an REBa₂Cu₃O₇₋ₓ phase (123 phase) in which an RE₂BaCuO₅ phase (211 phase) is dispersed functions as a source of generation of a magnetic field such as a permanent magnet in a superconducting state due to magnetization. The strength of the magnetic field which is generated is roughly proportional to the size and critical current density of the superconducting bulk magnet. For example, in the case of the columnar-shaped superconducting bulk magnet such as shown in FIG. 3, by magnetization by stationary magnetic field magnetization, the magnetic field strength at the center of the columnar surface becomes proportional to the diameter (D) and the critical current density (J_{c}). The critical current density J_{c} changes depending on the cooling temperature of the superconducting bulk magnet. In general, the lower the temperature, the higher the critical current density J_{c}. For example, in a diameter 45 mm and thickness 15 mm silver-containing Gd-based superconducting bulk material, by reinforcing the outer circumference part by a stainless steel ring, formation of a 1.8T magnetic field at 77K, a 3.8T field at 70K, and a 7.0T field at 60K has been reported (NPLT 5). That is, by magnetization at a lower temperature, a superconducting bulk magnet which generates a higher strength magnetic field can be obtained.

In the past, a metal ring was fit over the outer circumference of such a columnar-shaped or ring-shaped superconducting bulk magnet in a room temperature state, the assembly was cooled to the magnetization temperature, and the difference in heat expansion coefficients was utilized so as to suppress the hoop force which was generated by the magnetic field which was trapped at the superconducting bulk magnet and prevent fracture of the superconducting bulk magnet. By this method, diameter 30 mm or more relatively large sized superconducting bulk magnets with a magnetic flux density of 6 to 9T or so have been reported. However, there are also reports of fracture of the superconducting bulk magnet even at this level of magnetic field strength (NPLTs 6 and 7). In particular, the art of reinforcement for preventing fracture in an over diameter 50 mm large sized superconducting bulk magnet in the low temperature region (in particular 20 to 50K) was incomplete.

PLT 10 discloses a method of arranging a metal ring at the outer circumference of a columnar-shaped superconducting bulk magnet and filling a resin between the superconducting bulk magnet and ring. PLT 11 discloses the method of forming the outer circumferential diameter of the superconducting bulk magnet and the inner circumferential diameter of the metal reinforcement ring by a high dimensional precision and filling the slight clearance between the ring and the superconducting bulk magnet with a resin.

PLTs 12 and 13 disclose a method of impregnating a resin in the microcracks in a superconducting bulk magnet, then arranging reinforcing resin around the superconducting bulk magnet. PLT 14 discloses the method of arranging a block-shaped high strength material for supporting the outer circumference at the outer circumference part of a ring-shaped superconducting bulk magnet. In particular, FIG. 2 of PLT 14 discloses a superconducting bulk magnet comprised of a ring-shaped superconducting bulk magnet at the inside of which overall a high strength material for supporting the inner circumference is arranged.

Even with these reinforcement methods, when a diameter 50 mm or more relatively large sized superconducting bulk magnet is fully magnetized in the less than 50K low temperature region (state where superconducting bulk magnet as a whole is magnetized to a critical state), the reinforcement is insufficient for a 5T or more high strength magnetic field. At the present point of time, a stable reinforcing method with good reproducibility cannot be obtained. This is because inherently the strength of an oxide superconducting bulk magnet is a low one of 70 MPa or so, so just reinforcement of the outer circumference is insufficient.

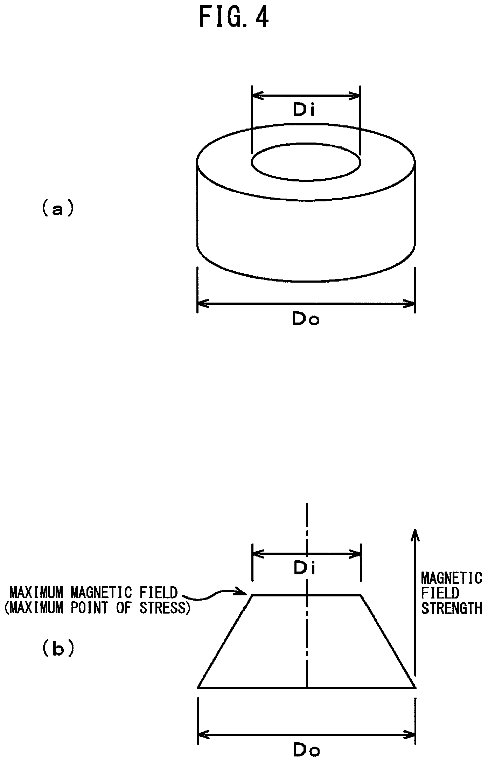

More specifically, when fully magnetizing a columnar-shaped or ring-shaped superconducting bulk magnet, the distribution of the magnetic field strength of the surface of the magnet becomes as shown in FIG. 3(a). That is, in a columnar shape, as shown in FIG. 3(b), it becomes a cone shape having a peak at substantially the center of the surface. In the case of the ring shape such as shown in FIG. 4(a), as shown in FIG. 4(b), the distribution becomes a frustoconical shape with the part corresponding to the inner circumference becoming the top surface. Further, in these cases, the position where the maximum tensile stress acts becomes the center in the case of a columnar shape and becomes the inner circumferential side surface (inner circumference part) in the case of a ring shape. Further, when a fracture occurs, often the position of the magnetic stress becomes the starting point of fracture. For example, in the case of a columnar shape, a compressive stress is applied from the outer circumference due to the metal ring. At the center part, that compressive strength is weakened, so the center where the hoop force becomes maximum becomes the starting point of fracture. That is, when the compressive stress from the metal ring which is arranged at the outer circumference is the same, the larger the diameter of the column shape, the smaller the stress affecting the center part from the metal ring.

PLT 10 shows methods of reinforcing various shapes of superconducting bulk magnets by using support members which are arranged around the superconducting bulk magnets. However, a superconducting bulk magnet which is comprised of a ring-shaped superconducting bulk magnet which is reinforced by a high strength metal ring at its outer circumference and a center core material at its inner side which are arranged in a nested manner for reinforcement is not disclosed at all. Further, the method of reinforcing a ring-shaped superconducting bulk magnet from the inner circumference side is also not suggested at all.

PLT 11 also discloses a method of reinforcing the circumference of a columnar or cylindrical superconducting bulk magnet by a high strength metal ring, but a superconducting bulk magnet which is comprised of a ring-shaped superconducting bulk magnet which is reinforced by a high strength metal ring at its outer circumference and a center core material which are arranged in a nested manner for reinforcement is not disclosed at all. Further, a method of reinforcing a ring-shaped superconducting bulk magnet from the inner circumference side is not suggested at all.

PLTs 12 and 13 disclose oxide superconductors which are reinforced by tightly bound covering layers of resin-impregnated layers and resin-impregnated cloth and are resistant to deterioration due to corrosion. However, a superconducting bulk magnet which is comprised of a ring superconducting bulk magnet which is reinforced at its outer circumference by a high strength metal ring and a center core material which is arranged in a nested manner for reinforcement is not disclosed at all. Further, the method of reinforcing a ring-shaped superconducting bulk magnet from the inner circumference side is not suggested at all.

PLT 14 discloses a superconducting bulk magnet characterized by covering a superconducting bulk magnet which has a through path by a high strength material. However, a superconducting bulk magnet which is comprised of a ring superconducting bulk magnet which is reinforced at its outer circumference by a high strength metal ring and a center core material which is arranged in a nested manner for reinforcement is not disclosed at all. Further, regarding the method of reinforcing a ring-shaped superconducting bulk magnet from the inner circumference, FIG. 2 of PLT 14 discloses a reinforcing method using a high strength reinforcing material which completely buries the inner circumference part. However, use of a ring-shaped reinforcing material for reinforcement so that an internal magnetic field strength which can be effectively used is obtained is not suggested at all.

PLT 8 discloses a superconducting bulk magnet comprised of a ring superconducting bulk magnet and center core material which is arranged in a nested manner which are made integral by filling the clearance with solder. However, a superconducting bulk magnet which is comprised of a ring-shaped superconducting bulk magnet which is reinforced at its outer circumference by a high strength metal ring and a center core material which is arranged in a nested manner is not disclosed at all. Further, the method of reinforcing a ring-shaped superconducting bulk magnet by a high strength metal ring from the inner circumference side is not suggested at all.

PLT 9 discloses a superconducting bulk magnet which is made integral by burying solder in the clearance of concentric rings which have joints close to a ring shape. However, the superconducting bulk magnet has joints, so reinforcement by a metal ring is difficult. That is, a superconducting bulk magnet which is comprised of a ring-shaped superconducting bulk magnet which is reinforced by a high strength metal ring and a center core material which is arranged in a nested manner for reinforcement is not disclosed at all. Further, a method of reinforcing a ring-shaped superconducting bulk magnet by a metal ring from the inner circumference side is not suggested at all.

FIG. 1(b) of NPLT 4 describes a superconducting bulk magnet comprised of a diameter 48 mm, inside diameter 24 mm, height 21 mm ring-shaped superconducting bulk magnet inside of which an outside diameter 24 mm, thickness 1.0 mm aluminum ring and diameter 22 mm columnar-shape bulk sample are inserted with the entire clearances filled with an epoxy resin. Further, this magnet is shown as being more easily fractured compared with a conventional one where only an outer circumferential ring is attached (see FIG. 1(a)). However, a superconducting bulk magnet which is comprised of a ring-shaped superconducting bulk magnet which is reinforced at its outer circumference or a ring-shaped superconducting bulk magnet which is reinforced at its outer circumference and inner circumference which is arranged in a nested manner and filled with resin, grease, or solder at only part of the clearances is not disclosed at all.

In this way, the reinforcing methods which are described in these PLTs 8 to 14 are insufficient when a diameter 50 mm or more relatively large sized superconducting bulk magnet is fully magnetized in the less than 50K low temperature region (state where superconducting bulk magnet as a whole is magnetized in a critical state) or when a 5T or more high strength magnetic field is generated. A reinforcing method with good reproducibility and stability cannot be obtained. This is because originally the strength of a superconducting bulk magnet is a low one of around 70 MPa or so, so reinforcement of the outer circumference alone is insufficient.

The present invention has as its object (theme) the provision of an oxide superconducting bulk magnet comprised of an REBa₂Cu₃O₇₋ₓ phase in which an RE₂BaCuO₅ phase is dispersed which is free of fracture even if large in size (in particular has a diameter of 50 mm or more) and is being magnetized (at time of generation of a 5T or more magnetic field at temperature of less than 50K). Note that, in this Description, an oxide superconducting bulk magnet comprised of an REBa₂Cu₃O₇₋ₓ phase in which an RE₂BaCuO₅ phase is dispersed will be called a "superconducting bulk magnet".

### Solution to Problem

The inventors engaged in intensive studies for solving the above problem and obtained the following discovery. That is, they discovered that in the case of a ring-shaped superconducting bulk magnet, by reinforcing the outer circumference part and inner circumference part by reinforcing materials, it is possible to reinforce the inner circumference part at which the magnetic stress occurs and to trap the higher magnetic field at the inside of the superconducting bulk magnet. Due to the trapped magnetic field, stress in the direction tearing off the ring is applied to the inner circumference part of the ring-shaped superconducting bulk magnet, but the reinforcing material is directly inserted into the inner circumference part, so it is possible to reinforce this part against stress in a direction tearing off the ring.

In actuality, when reinforcing the inner circumferential surface of a single ring-shaped superconducting bulk magnet, precision processing technology is required and labor and cost may be required for the processing. Furthermore, the magnetic field space becomes smaller by exactly the amount of thickness of the reinforcing material which is fit at the inner circumference, so such a reinforcing method probably has never been considered.

On the other hand, a large stress is not generated in the axial direction of a columnar-shaped and ring-shaped superconducting bulk magnet, so there is no need to arrange a reinforcing material at the flat parts (surfaces other than the outer circumferential surface and inner circumferential surface). If stacking or arranging the reinforcing materials with clearances, the effective magnetic field space becomes narrower, so rather it is desirable not to provide any reinforcing material in the axial direction.

Further, they discovered that when combining a plurality of ring-shaped superconducting bulk magnets in a nested manner, by placing reinforcing materials at the ring-shaped superconducting bulk magnets and the superconducting bulk magnet of the center core part for reinforcing them, it is possible to effectively reinforce the center part where magnetic stress occurs.

Forming a columnar-shaped superconducting bulk magnet, for example, into an outer circumferential ring part and a center core part and reinforcing them with metal rings requires precision processing technology. Furthermore, the effective diameter of the superconducting material is reduced by the thickness of the reinforcement ring which is fit over the center core part. Due in part to this, up until now, a reinforcing method such as in the present invention does not seem to have been considered.

The present invention was made in view of these discoveries and has as its gist the following
(1) A (ring-shaped) oxide superconducting bulk magnet comprised an RE₂BaCuO₅ phase dispersed in an REBa₂Cu₃O₇₋ₓ phase, said ring-shaped oxide superconducting bulk magnet characterized by arranging a ring-shaped reinforcing material at an outer circumference part of said ring-shaped oxide superconducting bulk magnet and arranging a ring-shaped reinforcing material at an inner circumference part of said ring-shaped oxide superconducting bulk magnet Here, "RE" indicates a rare earth element or combination of the same, and "x" indicates an oxygen deficiency satisfying the relationship of 0<x≤0.2.
(2) The (ring-shaped) oxide superconducting bulk magnet according to (1), wherein said oxide superconducting bulk magnet can generate a 5T or higher magnetic flux density due to magnetization and has an outside diameter of 50 mm or more.
(3) The (ring-shaped) oxide superconducting bulk magnet according to (1) or (2), wherein a heat shrinkage rate of the reinforcing material of the outer circumference part at the time of cooling from room temperature to 77K is 0.16% or more and, furthermore, a heat shrinkage rate of the reinforcing material of the inner circumference part is -0.09% to 0.39%.
(4) The (ring-shaped) oxide superconducting bulk magnet according to (3), wherein a heat shrinkage rate of the reinforcing material of the inner circumference part at the time of cooling from room temperature to 77K is - 0.05% to 0.30%.
(5) A (ring-shaped) oxide superconducting bulk magnet comprised of a ring-shaped oxide superconducting bulk magnet according to any one of (1) to (4), wherein, at the inside of the oxide superconducting bulk magnet, one or more ring-shaped oxide superconducting bulk magnets having ring-shaped reinforcing materials at the outer circumference part and inner circumference part are arranged and combined. Here, "RE" indicates a rare earth element or combination of the same, and "x" indicates an oxygen deficiency satisfying the relationship of 0<x≤0.2.
(6) The (ring-shaped) oxide superconducting bulk magnet according to (5), wherein the reinforcing material at said inner circumference part is formed with a female thread, the reinforcing material at said outer circumference part of a ring-shaped oxide superconducting bulk magnet facing the reinforcing material at said inner circumference part is formed with a male thread, and the reinforcing material of the inner circumference part and the reinforcing material of the outer circumference part are joined by screwing together.
(7) The (ring-shaped) oxide superconducting bulk magnet according to (5), wherein at least part of the clearance between the reinforcing material of said inner circumference part and the reinforcing material of the outer circumference part of a ring-shaped oxide superconducting bulk magnet arranged at the inside of the reinforcing material of said inner circumference part is filled with at least one of resin, grease, or solder.
(8) The (ring-shaped) oxide superconducting bulk magnet according to any one of (5) to (7), wherein the thickness of the reinforcing material of the outer circumference part of the ring-shaped oxide superconducting bulk magnet arranged at the inside is changed according to the position.
(9) The (ring-shaped) oxide superconducting bulk magnet according to (8), wherein the thicknesses of said reinforcing materials become greater the further from the outside to the inside of said oxide superconducting bulk magnet.
(10) The (ring-shaped) oxide superconducting bulk magnet according to any one of (5) to (9), wherein the shapes of the top surface and bottom surface of said oxide superconducting bulk magnet are polygonal shapes, elliptical shapes, or oblong shapes.
(11) An oxide superconducting bulk magnet which is comprised of the ring-shaped oxide superconducting bulk magnet according to any one of (1) to (10), wherein, at the inside of the oxide superconducting bulk magnet, an oxide superconducting bulk magnet having a ring-shaped reinforcing material arranged at its outer circumference part is arranged and combined, and wherein at least part of the clearance between the oxide superconducting bulk magnet arranged at the inside and said ring-shaped oxide superconducting bulk magnet is filled with at least one of resin, grease, or solder.

### Advantageous Effects of Invention

According to the present invention, it is possible to provide an oxide superconducting bulk magnet which can stably generate a high magnetic field by magnetization. Further, fractures and cracks become harder to occur, so it is possible to provide an oxide superconducting bulk magnet which enables magnetization excellent in symmetry and uniformity. Furthermore, since the superconductors are arranged in a nested manner, it is possible to realize an oxide superconducting bulk magnet which forms a high magnetic field more simply by the pulse magnetization method, so it is possible to utilize a high magnetic field which could not be obtained by usual permanent magnets. The industrial effect is great.

### Brief Description of Drawings

FIG. 1 is a view which shows the distribution of stress in the case of cooling a core columnar-shaped superconducting bulk magnet and ring-shaped superconducting bulk magnet reinforced by metal reinforcing materials.
FIG. 2 is a view which shows the distribution of stress in the case of cooling in the state with only the outer circumference of the columnar-shaped superconducting bulk magnet reinforced by a ring-shaped metal reinforcing material.
FIGS. 3 are views which show the relationship between the shape of a columnar-shaped superconducting bulk magnet and a distribution of trapped magnetic field. FIG. 3(a) is a conceptual view which shows a current path of a columnar-shaped superconducting bulk magnet. FIG. 3(b) is a conceptual view which shows the distribution of magnetic field strength at the top surface of a columnar-shaped superconducting bulk magnet.
FIGS. 4 are views which show the relationship between the shape of a ring-shaped superconducting bulk magnet and a distribution of trapped magnetic field. FIG. 4(a) is a conceptual view which shows the form of a ring-shaped superconducting bulk magnet. FIG. 4(b) is a conceptual view which shows the distribution of magnetic field strength at the top surface of a ring-shaped superconducting bulk magnet.
FIGS. 5 are views which show the structures of a sample AB and sample C which were prepared in Example 1. FIG. 5(a) is a conceptual view which shows the structure of the sample AB, while FIG. 5(b) is one which shows the structure of the sample C.
FIGS. 6 are views which show the structures of a sample D, sample E, and sample F which were prepared in Example 2. FIG. 6(a) is a conceptual view which shows the structure of the sample D, FIG. 6(b) is one which shows the structure of the sample E, and FIG. 6(c) is one which shows the structure of the sample F.
FIGS. 7 are views which show the structures of a sample HG and sample I which were prepared in Example 3. FIG. 7(a) is a conceptual view which shows the structure of the sample HG, while FIG. 7(b) is one which shows the structure of the sample I.
FIGS. 8 are views which show the structures of a sample KJ and sample L which were prepared in Example 4. FIG. 8(a) is a conceptual view which shows the structure of the sample KJ, while FIG. 8(b) is one which shows the structure of the sample L.

### Description of Embodiments

An effective reinforcing method for preventing fracture of a superconducting bulk magnet is reinforcement of the vicinity of the part at which the largest stress acts. For example, in the case of a superconducting bulk magnet with an overall shape of a columnar shape, as shown in FIG. 1, reinforcement of the outer circumferential part of the columnar-shaped superconducting bulk member which is assembled at the inside in addition to the outer circumference part is effective. In a columnar-shape bulk material of the same outside diameter, the center part shown in FIG. 2 becomes smaller in compressive strength compared with the reinforcing material of the outer circumference part and falls in reinforcing effect (arrow marks in FIGS. 1 and 2 conceptually show magnitudes of stress due to outer circumference part reinforcing material). Further, as shown in FIG. 3, when magnetizing a columnar-shaped superconducting bulk magnet by a sufficiently large magnetic field, the maximum point of stress becomes the center (FIG. 3(b)). For this reason, reinforcing the part closer to the center part as shown in FIG. 1 is extremely effective. Further, for example, in the case of a superconducting bulk member with an overall shape of a ring shape, the magnetic stress point when using a sufficient magnetic field for magnetization, as shown in FIG. 4, becomes the inner circumference part (inner circumferential surface (also referred to as the "inner circumferential surface")) (FIG. 4(b)). Therefore, it is extremely effective to reinforce the inner circumference part by a reinforcing material etc.

From the above, the inventors engaged in intensive studies on what reinforcing structure should be adopted so as to reinforce with a high efficiency an outside diameter 50 mm or more RE-E-Ba-Cu-O-based oxide superconducting bulk magnet which can generate a 5T or more magnetic flux density by magnetization. As a result, they discovered to directly reinforce the inner circumference part of a ring-shaped oxide superconducting bulk magnet becoming the magnetic stress point by a reinforcing material compared with the past where only the outer circumference part had been reinforced by ring-shaped high strength metal. Furthermore, they discovered that by arranging ring-shaped oxide superconducting bulk magnets which are reinforced at their outer circumferences in combination in a nested manner, it is possible to form a columnar-shaped superconducting bulk magnet and effectively reinforce the center point forming the point of magnetic stress.

The RE-Ba-Cu-O-based oxide superconducting bulk magnet which is used in the present invention is a superconductor phase. It has the structure of a single-crystal type REBa₂Cu₃O₇₋ₓ phase (123 phase) (below, in this Description, sometimes simply referred to as the "123 phase") in which a non-superconducting phase of an RE₂BaCuO₅ phase (211 phase) (below, in this Description, sometimes simply referred to as the "211 phase") is finely dispersed. Here, the "single-crystal type" means not perfect single crystals, but includes shapes having defects such as low slant grain boundaries which do not obstruct practical use. These are so-called "quasi single crystals." Further, the single-crystal type (quasi single-crystal) is referred to since this is a crystal phase comprised of the 123 phase of a single crystal in which the 211 phase is finely (for example, 1 µm or so) dispersed. The "RE" in the REBa₂Cu₃O₇₋ₓ phase (123 phase) and RE₂BaCuO₅ phase (211 phase) indicates a rare earth element such as a single rare earth element of Y, La, Nd, Sm, Eu, Gd, Dy, Ho, Er, Tm, Yb, or Lu or a combination of the same. Further, the 123 phase which includes La, Nd, Sm, Eu, and Gd is off from the stoichiometric composition of 1:2:3. Ba is sometimes partially substituted at the RE sites. Even the case where this Ba is partially substituted is considered included in the REBa₂Cu₃O₇₋ₓ phase (123 phase) of the present invention. Further, in the nonsuperconducting phase of the RE₂BaCuO₅ phase (211 phase) as well, it is known that La and Nd differ somewhat from Y, Sm, Eu, Gd, Dy, Ho, Er, Tm, Yb, and Lu, the ratios of metal element becomes a nonstoichiometric composition, and the crystal structure differs. However, this case is considered included in the RE₂BaCuO₅ phase (211 phase) of the present invention. Further, the "x" of the REBa₂Cu₃O₇₋ₓ phase indicates oxygen deficiency and satisfies the relationship of 0<x≤0.2. This is because if the oxygen deficiency "x" is in such a range, the REBa₂Cu₃O₇₋ₓ phase exhibits a superconducting property as a superconductor.

The above-mentioned substitution of the Ba element tends to cause the critical temperature to fall. Further, in an environment with a smaller oxygen partial pressure, the substitution of the Ba element tends to be suppressed, so rather than the atmosphere, it is preferable to grow the crystal in a 0.1 to 1% oxygen atmosphere comprised of argon or nitrogen in which a slight amount of oxygen is mixed. Further, by the RE-Ba-Cu-O-based oxide superconducting bulk magnet containing silver, the mechanical strength and J_{c} characteristic tend to increase, so the silver is more preferably contained in 5 to 20 mass%. At this time, the 123 phase is off from the 1:2:3 stoichiometric composition and Ag is sometimes partially substituted at the Cu site, but this is also included in the 123 phase of the present invention.

The 123 phase can be formed by a peritectic reaction between the 211 phase and the liquid phase comprised of the composite oxide of Ba and Cu. That is, this is the reaction of 211 phase+liquid phase (composite oxide of Ba and Cu)->123 phase. Further, due to this peritectic reaction, the temperature at which the 123 phase can be formed (Tf: 123-phase forming temperature) is substantially related to the ionic radius of the RE element. Along with the decrease in the ionic radius, the Tf also becomes lower. Further, along with the low oxygen atmosphere and addition of silver, the Tf tends to fall.

An oxide superconducting bulk magnet which is comprised of a single-crystal 123 phase in which a 211 phase is finely dispersed is possible since when the 123 phase grows, the unreacted 211 particles are left in the 123 phase. That is, the oxide superconducting bulk magnet is formed by the reaction which is shown by the 211 phase+liquid phase (composite oxide of Ba and Cu)->123 phase+211 phase. The fine dispersion of the 211 phase in the oxide superconducting bulk magnet is extremely important from the viewpoint of improvement of the critical current density (J_{c}). By adding a slight amount of at least one of Pt, Rh, or Ce, grain growth of the 211 phase in the semimolten state (state comprised of 211 phase and liquid phase) is suppressed and as a result the 211 phase in the material is refined to about 1 µm or less. The amounts of addition are preferably Pt: 0.2 to 2.0 mass%, Rh: 0.01 to 0.5 mass%, and Ce: 0.5 to 2.0 mass% from the viewpoint of the amounts at which the refinement effect appears and the cost of materials. The added Pt, Rh, and Ce partially form solid solutions in the 123 phase. Further, the elements which could not form solid solutions form composite oxides with Ba and Cu and are present scattered in the material.

Further, the oxide superconducting bulk magnet has to have a high critical current density (J_{c}) even in a magnetic field. To satisfy this condition, a single-crystal 123 phase not containing high angle grain boundaries becoming weak links in a superconducting manner is effective. Furthermore, since there is a high J_{c} characteristic, pinning centers for stopping movement of magnetic flux are effective. What function as such pinning centers are the finely dispersed 211 phases. A large number are preferably more finely dispersed. Further, the 211 phase or other nonsuperconducting phase finely disperses in the easily cleavable 123 phase so as to mechanically strengthen the superconductor and plays an important role as a superconducting bulk magnet.

The ratio of the 211 phase in the 123 phase is preferably 5 to 35 vol% from the viewpoint of the J_{c} characteristic and mechanical strength. Further, the oxide superconducting bulk magnet generally contains 50 to 500 µm or so voids in 5 to 20 vol%. Furthermore, when adding silver, depending on the amount of addition, the case of making the 10 to 500 µm or so silver or silver compound over 0 vol% to 25 vol% is included.

Further, the oxygen deficiency of the oxide superconducting bulk magnet after the crystal growth shows the change of temperature of the semiconductor type resistivity at 0.5 or so. By annealing this 350°C to 600°C for 100 hours or so in an oxygen atmosphere depending on the RE system, oxygen is taken into the material, the oxygen deficiency becomes 0.2 or less, and a good superconducting characteristic is exhibited.

When fully magnetizing a ring-shaped oxide superconducting bulk magnet which is comprised of the above superconducting material, as shown in FIG. 4(b), the maximum point of stress becomes the inner circumference part of the ring (inner circumferential surface). However, in the past, as shown in FIG. 2, only metal 22 at the outer circumference part (outer circumferential surface) was used for reinforcement, so the stress received from the reinforcing material of the outer circumference part of the columnar-shape oxide superconducting bulk magnet 21 became weaker at the center part.

Therefore, by arranging the ring-shaped high strength reinforcing material at this inner circumference part (inner circumferential surface) and directly reinforcing it, the ring-shaped oxide superconducting bulk magnet is improved in strength. Therefore, as shown in FIG. 1, by using the ring-shaped high strength reinforcing material 2 which is arranged at the outer circumference part of the ring-shaped oxide superconducting bulk magnet 1 for reinforcement and using the ring-shaped high strength reinforcing material 3 which is arranged at the inner circumference part as well for reinforcement, it becomes possible to sufficiently reinforce the center part where the stress concentrates. For this reason, even if using magnetization to cause the formation of a high magnetic field, the ring-shaped oxide superconducting bulk magnet will no longer fracture due to that stress. Further, the clearance between the outer circumference part of the ring-shaped oxide superconducting bulk magnet and the ring-shaped reinforcing material 2 which is arranged at the outer circumference part and the clearance between the inner circumference part of the ring-shaped oxide superconducting bulk magnet and the ring-shaped reinforcing material 3 which is arranged at the inner circumference part are filled with at least one type of filler of a resin, grease, solder, etc. so as to fasten the reinforcing materials whereby a further reinforcing effect can be exhibited.

When using a ring-shaped oxide superconducting bulk magnet with an outside diameter of less than 50 mm to generate a less than 5T magnetic flux density by magnetization, the stress which concentrates at the inner circumference part does not necessarily become that large, so it is not necessarily required to provide a reinforcing material at the inner circumference part. However, when using a ring-shaped oxide superconducting bulk magnet with an outside diameter of 50 mm or more to generate a 5T or more magnetic flux density by magnetization, the stress which concentrates at the inner circumference part can no longer be ignored. Therefore, the present invention is preferably applied to a ring-shaped oxide superconducting bulk magnet with an outside diameter of 50 mm or more which can generate a 5T or more magnetic flux density due to magnetization.

The heat shrinkage rate when cooling the reinforcing material which reinforces the outer circumference part of the ring-shaped oxide superconducting bulk magnet from room temperature to 77K is preferably 0.16% or more since the heat shrinkage rate of the superconducting material is about 0.16%.

When reinforcing the inner circumference part of the ring-shaped oxide superconducting bulk magnet by a reinforcing material, the heat shrinkage rate when cooling the reinforcing material from room temperature to 77K is preferably -0.09% to 0.39% when the inside diameter of the magnet is 10 mm or more. As the ring-shaped high strength reinforcing material which reinforces the inner circumference part, for example, glass fiber reinforced plastic (GFRP) etc. may be mentioned. Of course, a metal may also be used.

When the heat shrinkage rate of the reinforcing material of the inner circumference part is smaller than -0.09%, the difference in the heat shrinkage rates of the oxide superconducting bulk magnet and reinforcing material becomes larger and a clearance is formed between the reinforcing material and the superconducting bulk magnet. For this reason, the reinforcement effect is remarkably reduced and fracture more easily occurs, so this is not preferable. Further, conversely, if the heat shrinkage rate of the reinforcing material of the inner circumference part is over 0.39% as well, the difference in the heat shrinkage rates of the oxide superconducting bulk magnet and reinforcing material becomes larger and a clearance is formed between the reinforcing material and the superconducting bulk magnet, the reinforcement effect is remarkably reduced, and fracture more easily occurs, so this is not preferable.

Further, when the inside diameter of the ring-shaped oxide superconducting bulk magnet is 25 mm or more, the length of the interface between the reinforcing material and the magnet become longer, so for similar reasons to the above, the heat shrinkage rate when cooling the reinforcing material of the inner circumference part from room temperature to 77K is more preferably -0.05% to 0.30%.

It is possible to combine a ring-shaped oxide superconducting bulk magnet which is reinforced by arranging reinforcing materials at its outer circumference part and inner circumference part and, arranged at its inside in a nested manner (concentric circles), a ring-shaped oxide superconducting bulk magnet which is reinforced by arranging reinforcing materials at its outer circumference part and inner circumference part. Due to this, it is possible to further raise the generated magnetic field strength and magnetic flux density and possible to raise the overall strength and reliably prevent fracture. The magnet which is arranged in the nested manner may be a single one, but may also be a plurality as required. When combining a ring-shaped oxide superconducting bulk magnet in a nested manner, the heat shrinkage rate when cooling the reinforcing material of the outer circumference part of the magnet from room temperature to 77K is similarly 0.16% or more.

Further, the clearance between the reinforcing material which reinforces the outer circumference part and the oxide superconducting bulk magnet may be filled with at least one type of filler of resin, grease, or solder at least at part of the clearance. In this case, filling 30% or less of the total volume (vol) of the clearance with resin, grease, or solder is preferable. If over 30%, the interference between the stress which is applied to the outside ring-shaped magnet and the stress which is applied to the inside magnet becomes greater and fracture more easily occurs. As the resin, when producing oxide superconducting bulk magnets, then fastening them semipermanently, filling a curable resin is preferable. Further, when making the nested ring-shaped oxide superconducting bulk magnet detachable, use of grease or solder is preferable.

Between the reinforcing material of the outer circumference part and the ring-shaped oxide superconducting bulk magnet, it is preferable to uniformly fill the entire circumference with at least one type of filler of resin, grease, or solder and apply compressive stress equally to the ring-shaped oxide superconducting bulk magnet. As the type of reinforcing material of the outer circumference part, for example, copper, aluminum, stainless steel, etc. may be mentioned. During pulse magnetization, in a good conductor, a large breaking current flows, so stainless steel or other alloy material with a high specific resistance is more preferable. Further, when using a reinforcing material for semipermanent fastening, it is preferable to use a curable resin for fastening. Further, to enable detachment of the reinforcing material, solder or grease may be used for fastening. When using solder, heating to its melting point enables detachment, while when using grease, detachment becomes possible at ordinary temperature.

When using solder for fastening, the reinforcing material and oxide superconductor are fastened at the melting point of the solder used, so when using a high melting point solder, compared with when using low melting point solder, the compressive stress at the cooling temperature which is used in the superconducting state becomes larger. By adjusting the solder melting point which is used in this way, it is possible to control the compressive stress at the time of cooling and possible to make suitable adjustment so that a balance is obtained with the Lorentz force at the time of magnetization. The solder is comprised of mainly an alloy of Sn, Bi, Pb, Cd, In, Ag, Cu, etc. The melting point is, with a solder which has a ratio of composition (mass ratio) of Bi (44.7), Sn (22.6), Sn (8.3), Cd (5.3), and In (19.1), a relatively low melting point of 46.7°C. Further, with solder of a eutectic composition of Sn (96.5) and Ag (3.5), the relative melting point is a high 221°C. Further, solder not containing Pb or Cd or other highly toxic elements is more preferable. Furthermore, in the case of solder, the heat conductivity rate is higher than a resin or grease and therefore the temperature inside of the oxide superconducting bulk magnet can be easily maintained uniform.

When combining a magnet with an outer circumference part and inner circumference part reinforced by ring-shaped reinforcing materials and, inside of that, a magnet with an outer circumference part and inner circumference part reinforced by ring-shaped reinforcing materials in a nested manner, it is possible to form a female thread (or male thread) at the reinforcing material of the inner circumference part of the outside magnet, form a male thread (female thread) at the reinforcing material of the outer circumference part of the inside magnet, and join the two by screwing them together. The stress in the axial direction of an oxide superconducting bulk magnet in the magnetized state is relatively small, but force is generated due to deviation of the respective axes, so joining by thread grooves is preferable. Thread grooves are formed by forming relief shapes at the reinforcing material, but this is mainly in the circumferential direction, so stress concentration is hard to occur. Further, there is clearance or play between the male threads and female threads. It is possible to substantially cut the transfer of stress between the magnets, so this is preferable. For this reason, strength design (reinforcement design) becomes relatively easy, so this is preferable.

When combining a magnet reinforced at the outer circumference part and inner circumference part by ring-shaped reinforcing materials and, inside that in a nested manner, a magnet reinforced at its outer circumference part and inner circumference part by ring-shaped reinforcing materials, it is preferable to fill part of the clearance between the reinforcing material at the inner circumference part of the outside magnet and the reinforcing material of the outer circumference part of the inside magnet with resin, grease, or solder since it is possible to ease the stress which occurs at the time of magnetization. In this case, filling 30% or less of the total volume (vol) of the clearance with resin, grease, or solder is preferable. If over 30%, the interference between the stress which is applied to the outside magnet and the stress which is applied to the inside magnet becomes greater and fracture more easily occurs. When producing such a combination of oxide superconducting bulk magnets, then fastening them semipermanently, filling a curable resin is preferable. Further, when making the nested ring-shaped oxide superconducting bulk magnet detachable, use of grease or solder is preferable.

Next, in the case of a magnet which is comprised of a plurality of ring-shaped oxide superconducting bulk magnets, reinforced by reinforcing materials at their outer circumference parts and inner circumference parts, arranged and combined in a nested manner, the thicknesses of the reinforcing materials can also be changed depending on the positions. In particular, it is preferable to make the thickness greater the more from the outside to the inside where a greater magnetic field stress is generated.

RE-Ba-Cu-O-based oxide superconducting bulk magnets which are arranged in a nested manner may be combinations of ones of the same RE component elements. Furthermore, it is also possible to combine a plurality of types of RE-Ba-Cu-O-based oxide superconducting bulk magnets of different RE component elements and arrange them in a nested manner. By changing the composition of the RE in consideration of the J_{c} characteristic of an RE-Ba-Cu-O-based oxide superconducting bulk magnet, it is possible to design an oxide superconducting bulk magnet which is improved in characteristics as a whole.

The shapes of the oxide superconducting bulk magnets which are arranged in a nested manner were illustrated up to here as being columnar shapes or ring shapes, but may be any shapes which have clearances which can limit movement of the magnetic flux during pulse magnetization. That is, suitable shapes which enable the desired magnetic field distribution to be obtained may be selected as oxide superconducting bulk magnets suitable for the different applications. For example, the shapes of the top and bottom surfaces of the oxide superconducting bulk magnets may be made triangular, square, pentagonal, hexagonal, heptagonal, octagonal, or other polygonal shapes to circular shapes, rectangular shapes, elliptical shapes, oblong shapes, etc. In these cases, the outside diameter of the oxide superconducting bulk magnet is made one corresponding to the shortest outside diameters of the different shapes.

From the viewpoint of practicality, at least one of the magnets is a ring-shaped oxide superconducting bulk magnet which has a shape of a hexagonal shape or higher polygonal shape to a circle or a ring-shaped oxide superconducting bulk magnet with a top surface or bottom surface which has an oblong shape is more preferable. If such a shape, manufacture (processing and assembly) is easy and a more uniform magnetic field can be obtained by a stronger magnetic field. Regarding such a polygonal shape, from the balance of the ease of working and assembly and the performance of the magnetic field which is obtained, a hexagonal shape or octagonal shape is more preferable.

Further, at the center part of a ring-shaped oxide superconducting bulk magnet, an oxide superconducting bulk magnet (for example, columnar shape) which is reinforced at its outer circumference part may be attached to form an integral oxide superconducting bulk magnet. In this case, the generated magnetic field strength and magnetic flux density can be further raised. Attachment of a ring-shaped magnet and columnar-shape magnet is preferable because it is possible to ease the stress which occurs at the time of magnetization by filling part of the clearance between the reinforcing material of the outer circumference part of the columnar-shape magnet and the inner circumference part of the ring-shaped magnet with resin, grease, or solder. Further, in the same way as explained above, it is possible to form a female thread (or male thread) at the reinforcing material of the ring-shaped magnet inner circumference part, form a male thread (or female thread) at the outer circumference part of the columnar-shape magnet, and join the two by screwing them together.

In the present invention, the ring-shaped oxide superconducting bulk magnet, as explained above, is an oxide superconducting bulk magnet which is comprised of an RE-Ba-Cu-O-based oxide superconducting bulk magnet, that is, REBa₂Cu₃O₇₋ₓ phase, in which an RE₂BaCuO₅ phase is dispersed. However, since a relatively large superconducting current can be run through the a-b plane of the REBa₂Cu₃O₇₋ₓ phase in the oxide superconducting bulk magnet, magnetization so that the magnetic flux runs at a right angle to the a-b plane is preferable. For this reason, the axis of rotational symmetry of the ring-shaped oxide superconducting bulk magnet preferably matches the c-axis of the REBa₂Cu₃O₇₋ₓ crystal.

Further, having the "a" axes of the REBa₂Cu₃O₇₋ₓ, crystals of the oxide superconducting bulk magnets vertically adjoining the axis of rotational symmetry of the ring-shaped oxide superconducting bulk magnet (hierarchical direction of nested arrangement) respectively arranged offset in a nested manner gives a more uniform magnetic field, so is more preferable.

The oxide superconducting bulk magnet of the present invention exhibits magnet characteristics excellent in magnetization performance able to give the desired magnetic field distribution. From this, the oxide superconducting magnet system using an oxide superconducting bulk magnet of the present invention is a system which enables a high magnetic field of the system as a whole to be simply generated by a lower amount of input energy and a system which is excellent in economicalness and environmental friendliness.

### Examples

### Example 1

Purity 99.9% reagents RE₂O₃ (RE: Gd), BaO₂, and CuO were mixed to give a molar ratio of the metal elements of Gd:Ba:Cu of 10:14:20 (that is, molar ratio of 123 phase:211 phase of final structure of 3:1). Furthermore, mixed powders to which Pt: 0.5 mass% and Ag₂O: 15 mass% were added were prepared. The mixed powders were calcined once at 900°C for 8 hours. The calcined powders were packed into inside diameter 72 mm cylindrical molds and shaped into thickness approximately 33 mm disk shapes. Further, Sm₂O₃ and Yb₂O₃ were used by methods similar to the above shaped articles so as to prepare thickness 4 mm Sm-based and Yb-based disk shaped articles. Furthermore, the shaped articles were compressed by an isostatic water pressure press at about 100 MPa.

These were stacked on an alumina support member in the order of the Sm-based, Yb-based, and Gd-Dy-based shaped articles (precursors) from the bottom and arranged in an oven. These precursors were raised in temperature in the atmosphere up to 700°C over 15 hours, up to 1040°C over 160 hours, and further up to 1170°C over 1 hour, held there over 30 minutes, raised in temperature up to 1030°C over 1 hour, and held there over 1 hour. During that time, an Sm-based seed crystal which was prepared in advance was used and the seed crystal was placed over the precursors in the semimolten state. The cleaved surface was placed over the precursor so that the orientation of the seed crystal, that is, the c-axis, became the normal line of the disk shaped precursors. After this, the sample was cooled in the air down to 1000 to 985°C over 250 hours to grow the crystal. Furthermore, it was cooled down to room temperature over about 35 hours to obtain an outside diameter about 54 mm, thickness about 24 mm Gd-based oxide superconducting material. Further, a similar method was used to further prepare two similar Gd-based oxide superconducting materials to thereby prepare a total of three (for later explained sample A, sample B, and sample C) samples. These materials had structures of REBa₂Cu₃O₇₋ₓ phase in which a 1 µm or so RE₂BaCuO₅ phase and 50 to 500 µm silver are dispersed.

Further, these three samples were annealed by oxygen, then processed. The sample A was processed to an outside diameter 50.0 mm, inside diameter 27.1 mm, and thickness 15.0 mm. Further, the sample B was processed to an outside diameter 25.0 mm and 15.0 mm columnar shape. The sample C was processed as a comparative material to an outside diameter 50.0 mm and thickness 15.0 mm.

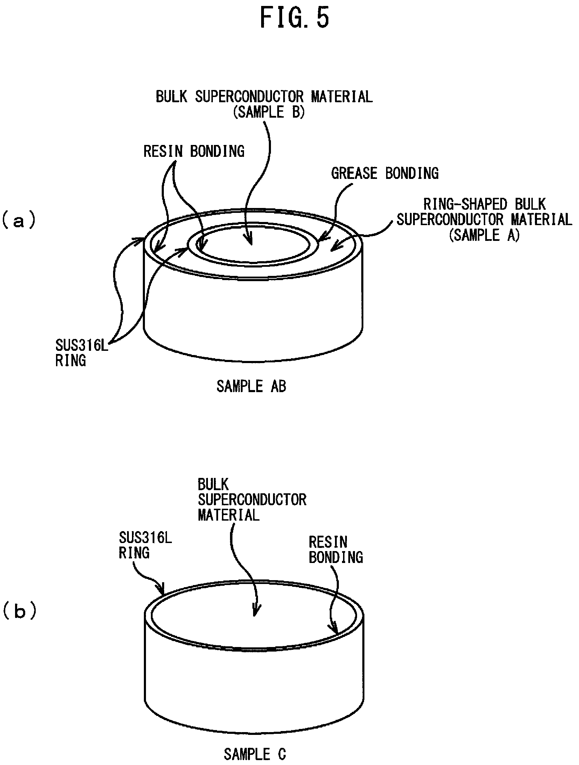

After that, at the outer circumference of the sample B, an outside diameter 27.0 mm, inside diameter 25.1 mm, thickness 0.95 mm SUS316L ring (below, simply referred to as a SUS316L ring) was arranged at the outer circumference part reinforcing material. This SUS316L ring and sample B were bonded by an epoxy resin over the entire circumference. Further, at the outer circumference of the sample A, an outside diameter 51.6 mm, inside diameter 50.1 mm, thickness 0.75 mm SUS316L ring was arranged as the outer circumference part reinforcing material. Similarly, an epoxy resin was used to bond the entire circumference. Further, in the sample A which was reinforced by a metal ring at the outer circumference part, the sample B was arranged. In eight-tenths of the clearance between the sample A and the reinforcing material of the outer circumference of the sample B, the equivalent of 45° in phase converted to center angle, grease was filled. This combined sample was made the sample AB. Further, at the outer circumference of the sample C, an outside diameter 51.6 mm, thickness 0.75 mm SUS316L ring was arranged as the outer circumference part reinforcing material. Similarly, an epoxy resin was used to bond the entire circumference. FIGS. 5 show the structures of the sample AB (FIG. 5(a)) and sample C (FIG. 5(b)).

In these sample AB and sample C, to measure the trapped magnetic flux density at the surface, five Hall elements were attached at 10 mm intervals in a line which passes through the centers of the surfaces of the samples. At this time, the third Hall element was set to become the center of the samples. First, for the magnetization at 70K, the sample was arranged in a 6.0T magnetic field at room temperature and cooled by a freezing machine to 70K, then the external magnetic field was reduced to zero by a 0.2T/min demagnetization rate. At this time, in the sample AB, the third Hall element had the largest value at 3.95T. Further, in the sample C, similarly the value was 3.98T. Next, the sample was magnetized at 60K. It was arranged at room temperature in a 10.0T magnetic field and cooled by a freezing machine to 60K, then the external magnetic field was reduced to zero by a 0.2T/min demagnetization rate. At this time, in the sample AB, the third Hall element gave the largest value at 6.90T. Further, in sample C, the value was similarly 6.95T. Next, similarly, in the sample AB, the third Hall element gave the maximum value or 6.90T. Further, in the sample C, the value was similarly 6.95T. Next, similarly, for the trapped magnetic flux density when applying a 14T magnetic field at room temperature, cooling to 50K, and making the external magnetic field zero, in the sample AB, the third Hall element gave the maximum value of 10.22T. Further, in the sample C, the first Hall element gave a value of 1.35T, the second Hall element gave a value of 2.75T, the third Hall element gave a value of 0.35T, the fourth Hall element gave a value of 3.02T, and the fifth Hall element gave a value of 1.35T. At the center part, the trapped magnetic flux density fell. After the experiment, the sample C was taken out from the freezing machine and checked at its surface, whereupon linear fractures could be confirmed passing near the center.

From these comparative experiments, it is clear that a superconducting bulk magnet which comprises ring-shaped superconducting bulk magnets which are reinforced at outer circumference parts arranged in a nested manner (sample AB of invention example) can trap (generate) an over 10T high magnetic flux density without fracture compared with a superconducting bulk magnet which is reinforced at only the outer circumference part (sample C of comparative example).

### Example 2

Purity 99.9% reagents RE₂O₃ (RE: Gd and Dy), BaO₂, and CuO were mixed to give a molar ratio of the metal elements of Gd:Dy:Ba:Cu of 8:2:14:20 (that is, molar ratio of 123 phase:211 phase of final structure of 3:1). Furthermore, mixed powders to which Pt: 0.4 mass% and Ag₂O: 18 mass% were added were prepared. The mixed powders were calcined once at 880°C for 8 hours. The calcined powders were packed into inside diameter 82 mm cylindrical molds and shaped into thickness approximately 33 mm disk shapes. Further, Sm₂O₃ and Yb₂O₃ were used by methods similar to the above shaped articles so as to prepare thickness 4 mm Sm-based and Yb-based disk shaped articles. Furthermore, the shaped articles were compressed by an isostatic water pressure press at about 100 MPa.

These were stacked on an alumina support member in the order of the Sm-based, Yb-based, and Gd-Dy-based shaped articles (precursors) from the bottom and arranged in an oven. These precursors were raised in temperature in the atmosphere up to 700°C over 15 hours, up to 1040°C over 160 hours, and further up to 1170°C over 1 hour, held there over 30 minutes, raised in temperature up to 1030°C over 1 hour, and held there over 1 hour. During that time, an Sm-based seed crystal which was prepared in advance was used and the seed crystal was placed over the precursors in the semimolten state. The cleaved surface was placed over the precursors so that the orientation of the seed crystal, that is, the c-axis, became the normal line of the disk shaped precursors. After this, the sample was cooled in the air down to 995 to 980°C over 300 hours to grow the crystal. Furthermore, it was cooled down to room temperature over about 35 hours to obtain an outside diameter about 63 mm, thickness about 35 mm Gd-DY-based oxide superconducting material. Further, a similar method was used to further prepare two similar Gd-DY-based oxide superconducting materials to thereby prepare a total of three (for later explained sample D, sample E, and sample F) samples. These materials had compositions of an REBa₂Cu₃O₇₋ₓ phase in which a 1 µm or so RE₂BaCuO₅ phase and 50 to 500 µm silver were dispersed. These samples were annealed in a stream of oxygen, then were processed into outside diameter 60.0 mm, inside diameter 30.1 mm, thickness 20.0 mm ring shapes.

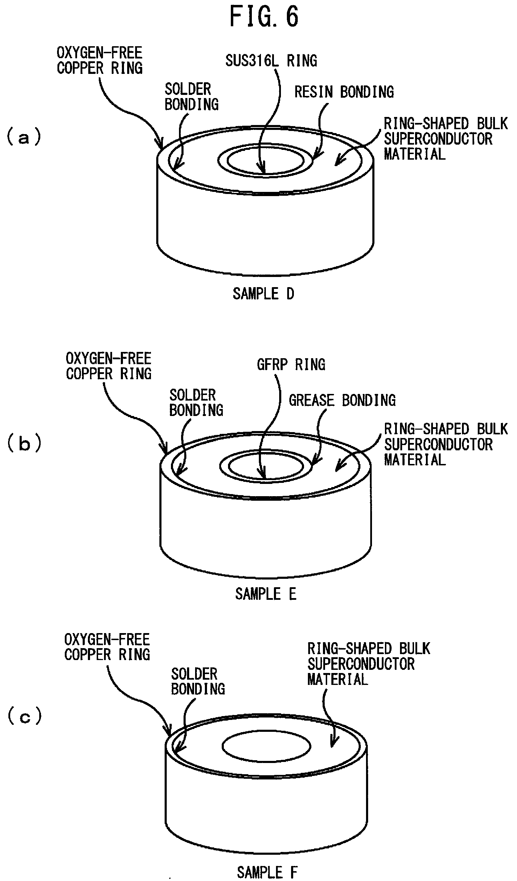

At each of the samples D, E, and F processed into ring shapes, a thickness 2.0 mm oxygen-free copper metal ring (outside diameter 64.0 mm, inside diameter 60.1 mm) was arranged at the outer circumference part as a reinforcing material. The entire circumference was bonded by solder. Furthermore, at the sample D, a thickness 1.0 mm SUS316L ring (outside diameter 30.0 mm, inside diameter 28.0 mm, height 20.0 mm) was fit in the inner circumference part as a reinforcing material. An epoxy resin was used to bond the entire circumference. The heat shrinkage at the time of cooling the SUS316L used from room temperature to 77K was measured. The result was 0.25%. At the sample E, as a reinforcing material, a thickness 2.0 mm (outside diameter 30.0 mm, inside diameter 26.0 mm, height 20.0 mm) ring which was cut from a pipe of glass-fiber reinforced plastic (GFRP) which was comprised of glass fiber (or glass fiber cloth) wound up in a concentric circular shape was fit, then grease was used to bond and fasten the entire circumference. The heat shrinkage at the time of cooling from room temperature to 77K in the fiber direction of the GFRP used at this time was 0.1%. The sample F is a comparative material which was not reinforced at the inner circumference part. FIGS. 6 show the structures of the sample D (FIG. 6(a)), sample E (FIG. 6(b)), and sample F (FIG. 6(c)).

In each of these sample D, sample E, and sample F, to measure the trapped magnetic flux density in the sample, a Hall element was attached at a center position of the sample. First, for the magnetization at 70K, the sample was arranged in a 4.0T magnetic field at room temperature and cooled by a freezing machine to 70K, then the external magnetic field was reduced to zero by a 0.2T/min demagnetization rate. At this time, in each sample, the value was about the same at about 2.75T. Similarly, trapped magnetic field tests were run at 60K and 50K. At 60K, the sample was cooled in a 6.0T external magnetic field, whereupon about 4.7T or substantially the same value was exhibited. At 50K, when cooling in a 8.0T external magnetic field, about 6.8T or about the same value was exhibited. However, at 40K, when cooling in a 10T external magnetic field and conducting a trapped magnetic field test, the sample D and sample E of the present invention gave 8.9T high trapped magnetic flux densities, while the value of the Hall element of the sample F not reinforced at the inner circumference part was 0.12T. After the experiment, the samples were taken out from the freezing machine and checked for the presence of fractures, whereupon a fracture believed to be due to the magnetic force was confirmed in the sample F.

From these comparative experiments, it is clear that a superconducting bulk magnet which comprises a ring-shaped superconducting bulk magnet which is reinforced an inner circumference part (sample D and sample E of invention example) can trap (generate) an over 8T high magnetic flux density without fracture compared with a ring-shaped superconducting bulk magnet which is not reinforced at the inner circumference part (sample F of comparative example).

### Example 3

Purity 99.9% reagents RE₂O₃ (RE: Y), BaO₂, and CuO were mixed to give a molar ratio of the metal elements of Gd:Ba:Cu of 9:12:17 (that is, molar ratio of 123 phase:211 phase of final structure of 5:2). Furthermore, mixed powders to which BaCeO₃: 1.0 mass% and Ag₂O: 15 mass% were added were prepared. The mixed powders were calcined once at 900°C for 8 hours. The calcined powders were packed into inside diameter 85 mm cylindrical molds and shaped into thickness approximately 35 mm disk shapes. Further, Sm₂O₃ and Yb₂O₃ were used by methods similar to the above shaped articles so as to prepare thickness 4 mm Sm-based and Yb-based disk shaped articles. Furthermore, the shaped articles were compressed by an isostatic water pressure press at about 100 MPa.

These were stacked on an alumina support member in the order of the Sm-based, Yb-based, and Y-based shaped articles (precursors) from the bottom and arranged in an oven. These precursors were raised in temperature in the atmosphere up to 700°C over 15 hours, up to 1040°C over 160 hours, and further up to 1170°C over 1 hour, held there over 30 minutes, raised in temperature up to 1030°C over 1 hour, and held there over 1 hour. During that time, an Sm-Nd-based seed crystal which was prepared in advance was used and the seed crystal was placed over the precursors in the semimolten state. The cleaved surface was placed over the precursor so that the orientation of the seed crystal, that is, the c-axis, became the normal line of the disk shaped precursors. After this, the sample was cooled in the air down to 970 to 955°C over 280 hours to grow the crystal. Furthermore, it was cooled down to room temperature over about 35 hours to obtain an outside diameter about 67 mm, thickness about 25 mm Y-based oxide superconducting material. Further, a similar method was used to further prepare two similar Y-based oxide superconducting materials to thereby prepare a total of three (for later explained sample H, sample G, and sample I) samples. These materials had compositions of an REBa₂Cu₃O₇₋ₓ phase in which a 1 µm or so RE₂BaCuO₅ phase and 50 to 500 µm silver were dispersed.

Further, these three samples were annealed by oxygen, then processed. The sample G was processed to an outside diameter 65.0 mm, inside diameter 36.1 mm, and thickness 20.0 mm. Further, the sample H was processed to an outside diameter 30.0 mm and thickness 20.0 mm columnar shape. The sample I was processed, as a comparative material, to an outside diameter 65.0 mm and thickness 20.0 mm.

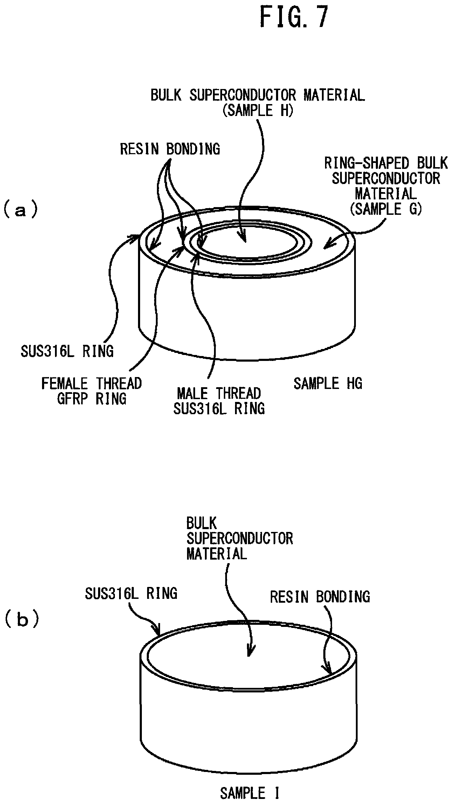

At the outer circumference of the sample H, as a reinforcing material, an SUS316L ring of an outside diameter about 33.5 mm, inside diameter 30.1 mm, and thickness about 1.5 mm formed with a male thread at the outer circumference part (surface forming outer circumferential side) was arranged. The SUS316L ring and the sample H were bonded over the entire circumference by an epoxy resin. Further, at the inner circumference part of the sample G, as the reinforcing material, an outside diameter 36.0 mm, inside diameter 32.5 mm, and thickness about 1.5 mm GFRP ring was similarly bonded over the entire circumference by an epoxy resin. Furthermore, in the sample G which was reinforced at the outer circumference part by an outside diameter 67.0 mm, thickness 1.0 mm SUS316L ring, a sample H was arranged. The sample G and the sample H were joined together by threaded grooves. This integrally formed sample was designated as the sample HG. Further, at the outer circumference part of the sample I, as a reinforcing material, an outside diameter 67.0 mm, thickness 1.0 mm SUS316L ring was arranged. Similarly, an epoxy resin was used to bond the entire circumference. FIGS. 7 shows the structures of the sample HG (FIG. 7(a)) and sample F (FIG. 7(b)).

In these sample HG and sample I, to measure the trapped magnetic flux density at the surface, five Hall elements were attached at 10 mm intervals in a line which passes through the centers of the surfaces of the samples. At this time, the third Hall element was set to become the center of the samples. First, for the magnetization at 70K, the sample was arranged in a 6.0T magnetic field at room temperature and cooled by a freezing machine to 70K, then the external magnetic field was reduced to zero by a 0.2T/min demagnetization rate. At this time, in the sample HG, the third Hall element had the largest value at 5.15T. Further, in the sample I, similarly the value was 5.12T. Next, the sample was magnetized at 60K. It was arranged at room temperature in a 10.0T magnetic field and cooled by a freezing machine to 60K, then the external magnetic field was reduced to zero by a 0.2T/min demagnetization rate. At this time, in the sample HG, the third Hall element gave the largest value at 8.95T. Further, in sample I, the first Hall element gave a value of 2.5T, the second Hall element gave a value of 3.5T, the third Hall element gave a value of 0.23T, the fourth Hall element gave a value of 3.2T, and the fifth Hall element gave a value of 1.8T. At the center part, the trapped magnetic flux density fell. After the experiment, the sample I was taken out from the freezing machine and checked, whereupon linear fractures could be confirmed passing near the center.

From these comparative experiments, it is clear that a superconducting bulk magnet which comprises superconducting bulk magnets which are reinforced by ring-shaped metal reinforcing materials arranged in a nested manner (sample HG of invention example) can trap (generate) a 10T class high magnetic flux density without fracture compared with a superconducting bulk magnet which reinforces only the outer circumference part by a metal ring (sample I of comparative example).

### Example 4

Purity 99.9% reagents RE₂O₃ (RE: Y), BaO₂, and CuO were mixed to give a molar ratio of the metal elements of Gd:Ba:Cu of 9:12:17 (that is, molar ratio of 123 phase:211 phase of final structure of 5:2). Furthermore, mixed powders to which BaCeO₃: 1.0 mass% and Ag₂O: 15 mass% were added were prepared. The mixed powders were calcined once at 900°C for 8 hours. The calcined powders were packed into inside diameter 110 mm cylindrical molds and shaped into thickness approximately 40 mm disk shapes. Further, Sm₂O₃ and Yb₂O₃ were used by methods similar to the above shaped articles so as to prepare thickness 4 mm Sm-based and Yb-based disk shaped articles. Furthermore, the shaped articles were compressed by an isostatic water pressure press at about 100 MPa.

These were stacked on an alumina support member in the order of the Sm-based, Yb-based, and Gd-Dy-based shaped articles (precursors) from the bottom and arranged in an oven. These precursors were raised in temperature in the atmosphere up to 700°C over 15 hours, up to 1040°C over 160 hours, and further up to 1170°C over 1 hour, held there over 30 minutes, raised in temperature up to 1030°C over 1 hour, and held there over 1 hour. During that time, an Sm-Nd-based seed crystal which was prepared in advance was used and the seed crystal was placed over the precursors in the semimolten state. The cleaved surface was placed over the precursor so that the orientation of the seed crystal, that is, the c-axis, became the normal line of the disk shaped precursors. After this, the sample was cooled in the air down to 970 to 955°C over 320 hours to grow the crystal. Furthermore, it was cooled down to room temperature over about 35 hours to obtain an outside diameter about 85 mm, thickness about 30 mm Y-based oxide superconducting material. Further, a similar method was used to further prepare two similar Y-based oxide superconducting materials to thereby prepare a total of three (for later explained sample K, sample J, and sample L) samples. These materials had compositions of a YBa₂Cu₃O₇₋ₓ phase in which a 1 µm or so Y₂BaCuO₅ phase and 50 to 500 µm silver were dispersed.

Further, these three samples were annealed by oxygen, then processed. The sample J was processed to an outside diameter 79.9 mm, inside diameter 58.1 mm, and thickness 25.0 mm. Further, the sample K was processed to an outside diameter 51.9 mm, inside diameter 30.1 mm, and thickness 25.0 mm columnar shape. The sample L was processed, as a comparative material, to an outside diameter 79.9 mm, inside diameter 30.1 mm, and thickness 25.0 mm.

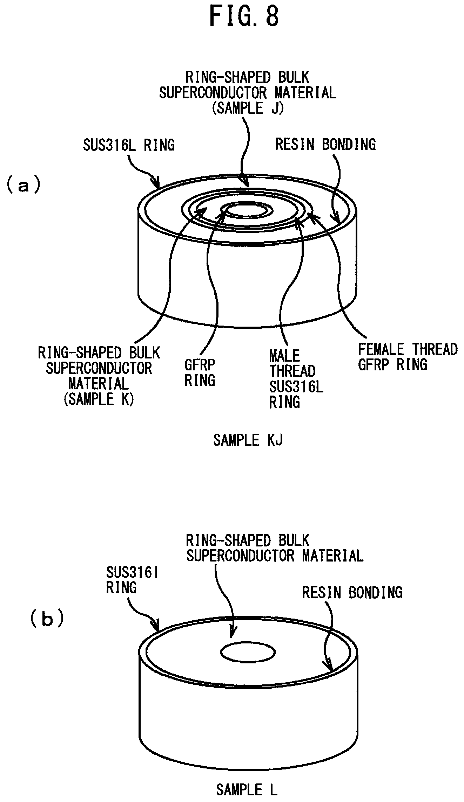

At the outer circumference of the sample K, as a reinforcing material, an SUS316L ring of an outside diameter about 55.9 mm, inside diameter 52.1 mm, and thickness about 2.0 mm formed with a male thread at the outer circumference part was arranged. The SUS316L ring and the sample K were bonded over the entire circumference by an epoxy resin. Further, at the inner circumference part of the sample K, as the reinforcing material, an outside diameter 29.9 mm, inside diameter 28.0 mm, and thickness about 1.0 mm GFRP ring was bonded over the entire circumference by an epoxy resin. Further, at the inner circumference part of the sample J, as a reinforcing material, an outside diameter 57.9 mm, inside diameter about 53.9 mm, thickness about 2.0 mm GFRP ring formed with a female thread was arranged. The entire circumference was bonded in the same way by an epoxy resin. Furthermore, in the sample J which was reinforced at the outer circumference part by an outside diameter 82.0 mm, inside diameter 79.9 mm, thickness 1.0 mm SUS316L ring, a sample K was arranged. The sample J and the sample K were joined together by threaded grooves. This integrally formed sample was designated as the sample KJ. Further, at the outer circumference part of the sample L, an outside diameter 78.0 mm, inside diameter 80.1 mm, thickness 1.0 mm SUS316L ring was arranged. Similarly, an epoxy resin was used to bond the entire circumference. FIGS. 8 show the structures of the sample KJ (FIG. 8(a)) and sample L (FIG. 8(b)).

In these sample KJ and sample L, to measure the trapped magnetic flux density at the surface, five Hall elements were attached at 17 mm intervals in a line which passes through the centers of the surfaces of the samples. At this time, the third Hall element was set to become the center of the samples. First, for the magnetization at 70K, the sample was arranged in a 5.0T magnetic field at room temperature and cooled by a freezing machine to 70K, then the external magnetic field was reduced to zero by a 0.2T/min demagnetization rate. At this time, in the sample KJ, the third Hall element had the largest value at 2.8T. Further, in the sample L, similarly the value was 3.0T. Next, the sample was magnetized at 55K. It was arranged at room temperature in a 8.0T magnetic field and cooled by a freezing machine to 55K, then the external magnetic field was reduced to zero by a 0.2T/min demagnetization rate. At this time, in the sample KJ, the third Hall element gave the largest value at 5.5T. Further, in the sample L, the first Hall element gave a value of 1.6T, the second Hall element gave a value of 2.7T, the third Hall element gave a value of - 0.21T, the fourth Hall element gave a value of 2.5T, and the fifth Hall element gave a value of 1.0T. At the center part, the trapped magnetic flux density fell. After the experiment, the sample L was taken out from the freezing machine and checked, whereupon linear fractures could be confirmed from near the center.

From these comparative experiments, it is clear that a superconducting bulk magnet which comprises superconducting bulk magnets which are reinforced at their outer circumference parts by metal rings and at their inner circumference parts by GFRP rings arranged in a nested manner (sample KJ of invention example) can trap (generate) a high magnetic flux density without fracture compared with a superconducting bulk magnet which reinforces only the outer circumference part by a metal ring (sample L of comparative example).

Note that the embodiments according to the present invention are not limited to any of the embodiments which are described in this Description.

### Industrial Applicability

The present invention can be utilized for an oxide superconducting bulk magnet which is relatively large in size and generates a high magnetic flux density. Due to this, it is possible to obtain a high magnetic field which cannot be obtained by usual permanent magnets with a high reproducibility and reliability.

### Reference Signs List

1. ring-shaped oxide superconducting bulk magnet
2. reinforcing material
3. reinforcing material
21. columnar-shape oxide superconducting bulk magnet
22. reinforcing material

## Claims

1. An oxide superconducting bulk magnet having a ring shape and comprising an RE₂BaCuO₅ phase dispersed in an REBa₂Cu₃O₇₋ₓ phase, said ring-shaped oxide superconducting bulk magnet **characterized by** arranging a ring-shaped reinforcing material at an outer circumference part of said ring-shaped oxide superconducting bulk magnet and arranging a ring-shaped reinforcing material at an inner circumference part of said ring-shaped oxide superconducting bulk magnet, where, "RE" indicates a rare earth element or combination of the same, and "x" indicates an oxygen deficiency satisfying the relationship of 0<x≤0.2.

2. The oxide superconducting bulk magnet according to claim 1, wherein said oxide superconducting bulk magnet can generate a 5T or higher magnetic flux density due to magnetization and has an outside diameter of 50 mm or more.

3. The oxide superconducting bulk magnet according to claim 1 or 2, wherein a heat shrinkage rate of the reinforcing material of said outer circumference part at the time of cooling from room temperature to 77K is 0.16% or more and, furthermore, a heat shrinkage rate of the reinforcing material of said inner circumference part is -0.09% to 0.39%.

4. The oxide superconducting bulk magnet according to claim 3, wherein a heat shrinkage rate of the reinforcing material of said inner circumference part at the time of cooling from room temperature to 77K is -0.05% to 0.30%.

5. An oxide superconducting bulk magnet comprised of said ring-shaped oxide superconducting bulk magnet according to any one of claims 1 to 4, wherein, at the inside of the oxide superconducting bulk magnet, one or more ring-shaped oxide superconducting bulk magnets having ring-shaped reinforcing materials at the outer circumference part and inner circumference part are arranged and combined, where, "RE" indicates a rare earth element or combination of the same, and "x" indicates an oxygen deficiency satisfying the relationship of 0<x≤0.2.

6. The oxide superconducting bulk magnet according to claim 5, wherein the reinforcing material at said inner circumference part is formed with a female thread, the reinforcing material at said outer circumference part of a ring-shaped oxide superconducting bulk magnet facing the reinforcing material at said inner circumference part is formed with a male thread, and the reinforcing material of the inner circumference part and the reinforcing material of the outer circumference part are joined by screwing together.

7. The oxide superconducting bulk magnet according to claim 5, wherein at least part of the clearance between the reinforcing material of said inner circumference part and the reinforcing material of the outer circumference part of a ring-shaped oxide superconducting bulk magnet arranged at the inside of the reinforcing material of said inner circumference part is filled with at least one of resin, grease, or solder.

8. The oxide superconducting bulk magnet according to any one of claims 5 to 7, wherein the thickness of the reinforcing material of the outer circumference part of the ring-shaped oxide superconducting bulk magnet arranged at the inside is changed according to the position.

9. The oxide superconducting bulk magnet according to claim 8, wherein the thicknesses of said reinforcing materials become greater the further from the outside to the inside of said oxide superconducting bulk magnet.

10. The oxide superconducting bulk magnet according to any one of claims 5 to 9, wherein the shapes of the top surface and bottom surface of said oxide superconducting bulk magnet are polygonal shapes, elliptical shapes, or oblong shapes.

11. An oxide superconducting bulk magnet which is comprised of the ring-shaped oxide superconducting bulk magnet according to any one of claims 1 to 10, wherein, at the inside of the oxide superconducting bulk magnet, an oxide superconducting bulk magnet having a ring-shaped reinforcing material arranged at its outer circumference part is arranged and combined, and
wherein at least part of the clearance between the oxide superconducting bulk magnet arranged at the inside and said ring-shaped oxide superconducting bulk magnet is filled with at least one of resin, grease, or solder.
